(19) Europäisches Patentamt
European Patent Office
Office européen des brevets

(11) **EP 2 415 085 B1**

(12) **EUROPÄISCHE PATENTSCHRIFT**

(45) Veröffentlichungstag und Bekanntmachung des Hinweises auf die Patenterteilung:
**02.01.2019 Patentblatt 2019/01**

(21) Anmeldenummer: **10707304.1**

(22) Anmeldetag: **10.03.2010**

(51) Int Cl.:
*H01L 33/32* (2010.01)     *B82Y 20/00* (2011.01)
*H01S 5/34* (2006.01)       *H01S 5/343* (2006.01)
*H01L 33/06* (2010.01)

(86) Internationale Anmeldenummer:
**PCT/EP2010/053047**

(87) Internationale Veröffentlichungsnummer:
**WO 2010/112310 (07.10.2010 Gazette 2010/40)**

(54) **OPTOELEKTRONISCHER HALBLEITERCHIP**

OPTOELECTRONIC SEMICONDUCTOR CHIP

PUCE SEMICONDUCTRICE OPTOÉLECTRONIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **30.03.2009 DE 102009015569**

(43) Veröffentlichungstag der Anmeldung:
**08.02.2012 Patentblatt 2012/06**

(73) Patentinhaber: **OSRAM Opto Semiconductors GmbH**
**93055 Regensburg (DE)**

(72) Erfinder:
• **AVRAMESCU, Adrian, Stefan**
**93051 Regensburg (DE)**
• **QUEREN, Désirée**
**93073 Neutraubling (DE)**
• **EICHLER, Christoph**
**93105 Tegernheim (DE)**
• **SABATHIL, Matthias**
**93059 Regensburg (DE)**
• **LUTGEN, Stephan**
**93186 Pettendorf (DE)**
• **STRAUSS, Uwe**
**93077 Bad Abbach (DE)**

(74) Vertreter: **Epping - Hermann - Fischer Patentanwaltsgesellschaft mbH Schloßschmidstraße 5 80639 München (DE)**

(56) Entgegenhaltungen:
EP-A1- 1 667 292      WO-A1-2007/023419
DE-A1-102007 044 439  JP-A- 2004 356 256
US-A1- 2005 116 216   US-A1- 2007 241 344
US-A1- 2008 283 822   US-A1- 2008 315 179

**Beschreibung**

Es wird ein optoelektronischer Halbleiterchip angegeben.

Die Druckschrift US 6,849,881 B1 betrifft ein optoelektronisches Halbleiterbauteil mit einer Multiquantentrogstruktur.

In der Druckschrift JP 2004-356256 A ist ein auf einem Nitrid basierendes, Licht emittierendes Halbleiterelement angegeben.

Ein Licht emittierendes, GaN-III-V-Halbleiterbauteil findet sich in der Druckschrift EP 1 667 292 A1.

Es offenbart die Druckschrift WO 2007/023419 A1 ein Licht emittierendes III-Nitrid-Bauteil.

In der Druckschrift US 2005/0116216 ist ein optisches Halbleiterbauteil mit einer Multiquantentopfstruktur beschrieben.

Eine zu lösende Aufgabe besteht darin, einen optoelektronischen Halbleiterchip mit einer Quantentrogstruktur anzugeben, der im Betrieb Strahlung mit einer hohen Effizienz erzeugt.

Diese Aufgabe wird gelöst durch einen optoelektronischen Halbleiterchip mit den Merkmalen des Anspruchs 1.

Gemäß der Erfindung basiert der optoelektronische Halbleiterchip auf einem Nitrid-Materialsystem. Mit anderen Worten ist eine Komponente des Halbleitermaterials, mit dem der Halbleiterchip hergestellt ist, Stickstoff. Bei dem Materialsystem handelt es sich also etwa um ein III-Nitrid-Halbleitermaterial. Zum Beispiel basiert der Halbleiterchip auf AlGaN, GaN, InGaN oder InAlGaN.

Der optoelektronische Halbleiterchip ist epitaktisch gewachsen. Durch das epitaktische Wachsen ist eine Wachstumsrichtung z definiert.

Der optoelektronische Halbleiterchip umfasst mindestens einen aktiven Quantentrog. Der Begriff Quantentrog entfaltet hierbei keine Bedeutung hinsichtlich der Dimensionalität der Quantisierung. Der Quantentrog kann somit ein nulldimensionaler Quantenpunkt, ein eindimensionaler Quantendraht oder ein mehrdimensionaler Quantentopf oder jede Kombination dieser Strukturen darstellen.

Gemäß zumindest einer Ausführungsform des optoelektronischen Halbleiterchips wird im Betrieb des Halbleiterchips in dem mindestens einen aktiven Quantentrog eine elektromagnetische Strahlung erzeugt. Eine Wellenlänge der elektromagnetischen Strahlung liegt bevorzugt im Spektralbereich zwischen 200 nm und 3000 nm, insbesondere im Spektralbereich zwischen einschließlich 360 nm und 540 nm.

Der mindestens eine aktive Quantentrog weist in einer Richtung parallel zu der Wachstumsrichtung z des Halbleiterchips N aufeinander folgende Zonen auf.

Zumindest zwei der Zonen weisen einen voneinander verschiedenen mittleren Indiumgehalt c auf. Das heißt, innerhalb des aktiven Quantentrogs ist der Indiumgehalt gezielt variiert.

Gemäß einer Abwandlung des Halbleiterchips erfüllt der aktive Quantentrog die folgende Bedingung:

$$40 \leq \int c(z)dz - 2{,}5N - 1{,}5\int dz \leq 80 \; .$$

Dass der mindestens eine aktive Quantentrog oben genannte Bedingung erfüllt, bedeutet, dass die Parameter Indiumgehalt c, Anzahl der Zonen N und Ausdehnung der Zonen sowie des aktiven Quantentrogs in einer Richtung parallel zur Wachstumsrichtung z so gewählt sind, dass das Integral über den Indiumgehalt c entlang der Wachstumsrichtung z innerhalb des aktiven Quantentrogs, subtrahiert um das 2,5-fache der Anzahl N der Zonen und subtrahiert um das 1,5-fache der Ausdehnung des aktiven Quantentrogs in einer Richtung parallel zur Wachstumsrichtung z zwischen einschließlich 40 und 80 liegt, bevorzugt zwischen einschließlich 50 und 70.

Indiumgehalt bedeutet hierbei, dass ein Anteil der Nicht-Stickstoffgitterplätze durch Indiumatome substituiert ist.

Der Indiumgehalt c ist dimensionslos in Prozent anzugeben. Das heißt, c weist einen dimensionslosen Zahlenwert zwischen einschließlich 0 und 100 auf. Die Anzahl N der Zonen ist ebenfalls dimensionslos in obige Bedingung einzusetzen. z ist ebenso dimensionslos und entspricht einer Koordinate entlang einer Richtung parallel zur Wachstumsrichtung z in Nanometer.

Ein solcher aktiver Quantentrog weist bezüglich des Indiumgehalts entlang der Wachstumsrichtung zumindest abschnittsweise eine gestufte und/oder rampenartige Form auf.

Durch diese rampenartige und/oder gestufte Struktur des aktiven Quantentrogs kann sich ein Überlapp der Wellenfunktionen im Valenzband und im Leitungsband erhöhen. Der vergrößerte Überlapp der Wellenfunktionen kann zu einer gesteigerten Effizienz des Halbleiterchips führen.

Ferner kann eine Ladungsträgereinfangrate erhöht sein. Mit anderen Worten wird mit hoher Wahrscheinlichkeit ein Ladungsträger, beispielsweise ein Elektron, in dem aktiven Quantentrog eingefangen und kann zur Strahlung emittierenden Rekombination dienen. Durch die Ausbildung von Heterogrenzen durch eine oder mehrere Stufen im Bereich einer Bandkante können lokalisierte Grenzflächenladungen erzeugt werden. Durch diese lokalisierten Grenzflächenladungen können zusätzlich Piezofelder reduziert sein, wodurch ebenfalls eine Effizienz der Strahlungserzeugung des Halbleiterchips gesteigert sein kann.

Die obige Bedingung bezüglich der Parameter des Quantentrogs, insbesondere im Hinblick auf die Dicken der Zonen und auf deren Indiumgehalt, gibt einen Parameterbereich zur Gestaltung des aktiven Quantentrogs an, über den eine überraschend hohe Effizienz und somit ein besonders hoher Wirkungsgrad bei der Strahlungserzeugung des Halbleiterchips erzielbar ist.

Der Wertebereich, den der Term $\int c(z)dz - 2{,}5N - 1{,}5 \int dz$ annehmen kann, unterliegt hierbei keinen prinzipiellen Beschränkungen. Beispielsweise kann der Term für herkömmliche aktive Quantentröge 200 übersteigen oder auch kleiner als 0 sein.

Gemäß der Erfindung erfüllt der mindestens eine aktive Quantentrog des optoelektronischen Halbleiterchips die folgende Bedingung:

$$40 \le \sum_{i=1}^{N} c_i w_i - 2{,}5N - 1{,}5 \sum_{i=1}^{N} w_i \le 80 \, ,$$

bevorzugt

$$50 \le \sum_{i=1}^{N} c_i w_i - 2{,}5N - 1{,}5 \sum_{i=1}^{N} w_i \le 70 \, .$$

$c_i$ ist hierbei der mittlere Indiumgehalt der i-ten Zone und $w_i$ eine Breite der i-ten Zone des mindestens einen aktiven Quantentrogs. Die Zonen des Quantentrogs sind in Richtung parallel zur Wachstumsrichtung z des Halbleiterchips fortlaufend nummeriert.

Beispielsweise ist eine Zone des aktiven Quantentopfs ein solcher Bereich, in dem der Indiumgehalt entlang der Wachstumsrichtung z lokal von einem über die gesamte Zone gemittelten Indiumgehalt um höchstens 30 %, bevorzugt um höchstens 15 %, abweicht. Mit anderen Worten bilden zum Beispiel ausgeprägte, stufenartige Anstiege oder Abfälle des Indiumgehalts Grenzen oder Grenzgebiete zwischen benachbarten Zonen.

Der Indiumgehalt c ist innerhalb der Zonen des mindestens einen aktiven Quantentrogs jeweils konstant, unter Berücksichtigung der Herstellungstoleranzen. Zum Beispiel kann konstant bedeuten, dass der Indiumgehalt c innerhalb der Zonen Abweichungen von einem Mittelwert um höchstens 2 Prozentpunkte, insbesondere um höchstens 1 Prozentpunkt, aufzeigt. Der Begriff konstant schließt beispielsweise nicht aus, dass Stufenkanten im Verlauf des Indiumgehalts längs einer Richtung parallel zur Wachstumsrichtung eine abgerundete Form aufweisen können. Mit anderen Worten ist der Verlauf des Indiumgehalts durch eine Stufenfunktion approximierbar.

Der mindestens eine aktive Quantentrog weist mindestens drei Zonen auf. Mit anderen Worten ist N größer oder gleich 3. Es weisen mindestens drei Zonen, bevorzugt alle Zonen, jeweils einen unterschiedlichen mittleren Indiumgehalt auf.

Gemäß der Erfindung weist der optoelektronische Halbleiterchip eine p-Anschlussseite und eine n-Anschlussseite auf. An der p-Anschlussseite des Halbleiterchips befindet sich zum Beispiel p-dotiertes Halbleitermaterial und an der n-Anschlussseite n-dotiertes Halbleitermaterial. Über die Anschlussseiten ist der Halbleiterchip bevorzugt elektrisch kontaktierbar.

Gemäß der Erfindung gilt für den mittleren Indiumgehalt c zumindest eines Teils der Zonen:
$c_i < c_{i+1}$ und $c_{i+1} > c_{i+2}$.

Die Zonen sind parallel zur Wachstumsrichtung von der p-Anschlussseite hin zur n-Anschlussseite fortlaufend nummeriert. Bevorzugt ist i = 1. Mit anderen Worten weist der aktive Quantentrog eine zentrale Zone mit einem hohen Indiumgehalt auf, die beidseitig von Zonen mit einem herabgesetzten Indiumgehalt umgeben ist.

Gemäß der Erfindung gilt weiterhin, dass $c_i < c_{i+2}$. Mit anderen Worten weist der aktive Quantentrog eine zentrale Zone mit einem hohen Indiumgehalt auf. Eine Zone, die sich näher an der p-Anschlussseite als die zentrale Zone befindet, weist einen kleineren Indiumgehalt auf als die Zone, die sich näher an der n-Anschlussseite befindet. Gemäß zumindest einer Ausführungsform des optoelektronischen Halbleiterchips gilt, in einer Richtung von der p-Anschlussseite hin zur n-Anschlussseite, für den mittleren Indiumgehalt für einen Teil der Zonen:
$c_i > c_{i+1}$ und $c_{i+2} > c_{i+1}$ und $c_i > c_{i+2}$.

Mit anderen Worten ist die Zone i+1 von zwei Zonen mit einem höheren Indiumgehalt umgeben. Die Zone i+1 stellt zum Beispiel eine Zwischenbarriere in dem Quantentrogprofil dar. Bevorzugt ist i = 1 oder i = 2.

Gemäß zumindest einer Ausführungsform des optoelektronischen Halbleiterchips umfasst der mindestens eine aktive Quantentrog zwischen einschließlich drei und zehn Zonen. Mit anderen Worten gilt: $3 \leq N \leq 10$, bevorzugt $3 \leq N \leq 6$. Gemäß zumindest einer Ausführungsform des optoelektronischen Halbleiterchips beträgt eine Gesamtbreite des aktiven Quantentrogs zwischen einschließlich 0,25 nm und 12 nm, insbesondere zwischen einschließlich 0,5 nm und 10 nm, bevorzugt zwischen einschließlich 3,5 nm und 8 nm.

Gemäß zumindest einer Ausführungsform des optoelektronischen Halbleiterchips befindet sich eine Zone mit geringerer Breite zwischen zwei Zonen größerer Breite.

Gemäß zumindest einer Ausführungsform des optoelektronischen Halbleiterchips gilt bezüglich der Breiten w für zumindest einen Teil der Zonen des aktiven Quantentrogs:

$w_i < w_{i+1}$ und $w_i < w_{i+2}$.

Bevorzugt ist hierbei die Zone i+1 diejenige Zone mit dem höchsten Indiumgehalt. Es ist also bevorzugt i = 1. Weiterhin kann insbesondere $w_{i+1} > w_{i+2}$ gelten.

Gemäß zumindest einer Ausführungsform des optoelektronischen Halbleiterchips ist eine Breite in einer Richtung parallel zur Wachstumsrichtung z der mindestens einen Zwischenbarriere des aktiven Quantentrogs kleiner als eine minimale Breite der weiteren Zonen des mindestens einen aktiven Quantentrogs. Mit anderen Worten ist die Zwischenbarriere dünn gestaltet. Insbesondere weist die Zwischenbarriere eine Dicke entlang der Wachstumsrichtung zwischen einschließlich 0,25 nm und 1,25 nm auf.

Gemäß zumindest einer Ausführungsform des optoelektronischen Halbleiterchips liegen die Dicken der Zonen, mit Ausnahme der Dicken von gegebenenfalls vorhandenen Zwischenbarrieren, zwischen einschließlich 1,5 nm und 4 nm, insbesondere zwischen einschließlich 1,75 nm und 3 nm.

Gemäß zumindest einer Ausführungsform des optoelektronischen Halbleiterchips liegt ein Indiumgehalt der Zone mit dem höchsten Indiumgehalt zwischen einschließlich 15 % und 50 %.

Gemäß zumindest einer Ausführungsform des optoelektronischen Halbleiterchips beträgt ein Indiumgehalt zumindest einer Zone, die der Zone mit dem maximalen Indiumgehalt benachbart ist, zwischen einschließlich 30 % und 80 %, insbesondere zwischen einschließlich 40 % und 60 % des mittleren Indiumgehalts der Zone mit dem maximalen Indiumgehalt.

Gemäß zumindest einer Ausführungsform des optoelektronischen Halbleiterchips gilt für den mittleren Indiumgehalt mindestens einer i-ten Zone, wobei bevorzugt i = 2 oder i > 2 ist:

$$0,35\ c_{i-1} \leq c_i \leq 0,65\ c_{i-1},$$

insbesondere

$$0,40\ c_{i-1} \leq c_i \leq 0,60\ c_{i-1}.$$

Gemäß zumindest einer Ausführungsform des optoelektronischen Halbleiterchips umfasst dieser, in einer Richtung parallel zur Wachstumsrichtung z, zwischen einschließlich zwei und fünf aktive Quantentröge. Mit anderen Worten weist der Halbleiterchip eine Multiquantentrogstruktur auf.

Gemäß zumindest einer Ausführungsform des optoelektronischen Halbleiterchips umfasst dieser mindestens einen inaktiven Quantentrog. Ein mittlerer Indiumgehalt des inaktiven Quantentrogs ist hierbei kleiner als der mittlerer Indiumgehalt der Zonen des mindestens einen aktiven Quantentrogs, die dem maximalen mittleren Indiumgehalt aufweist.

Inaktiv bedeutet, dass der inaktive Quantentrog nicht zu einer Strahlungserzeugung eingerichtet ist. Im Betrieb des Halbleiterchips wird also in dem mindestens einen inaktiven Quantentrog kein oder nur ein vernachlässigbar kleiner Anteil an der emittierten Strahlung erzeugt. Bevorzugt beträgt der in den inaktiven Quantentrögen erzeugte Strahlungsanteil weniger als 10 %, insbesondere weniger als 2 %.

Gemäß zumindest einer Ausführungsform des optoelektronischen Halbleiterchips ist eine Dicke des inaktiven Quantentrogs kleiner als eine Dicke des aktiven Quantentrogs, entlang einer Richtung parallel zur Wachstumsrichtung z. Bevorzugt beträgt die Dicke des inaktiven Quantentrogs höchstens 75 % der Dicke des aktiven Quantentrogs.

Gemäß zumindest einer Ausführungsform des optoelektronischen Halbleiterchips umfasst dieser mindestens zwei inaktive Quantentröge, die den mindestens einen aktiven Quantentrog einschließen.

Gemäß zumindest einer Ausführungsform des optoelektronischen Halbleiterchips befindet sich zwischen zwei benachbarten aktiven Quantentrögen wenigstens ein inaktiver Quantentrog, insbesondere zwischen einschließlich einem und fünf inaktiven Quantentrögen. Bevorzugt befindet sich auch zwischen der p-Anschlussseite und dem der p-Anschlussseite nächstgelegenen aktiven Quantentrog mindestens ein inaktiver Quantentrog, insbesondere zwischen einschließlich einem und fünf inaktiven Quantentrögen. Entsprechendes gilt bevorzugt auch für den der n-Anschlussseite nächstgelegenen aktiven Quantentrog.

Gemäß zumindest einer Ausführungsform des optoelektronischen Halbleiterchips weist dieser wenigstens zwei Wellenleiterschichten auf, wobei sich der mindestens eine aktive Quantentrog, insbesondere alle aktiven Quantentröge, zwischen den Wellenleiterschichten befinden. Mit anderen Worten ist der mindestens eine aktive Quantentrog von den Wellenleiterschichten eingeschlossen.

Gemäß zumindest einer Ausführungsform des optoelektronischen Halbleiterchips beinhaltet zumindest eine der Wellenleiterschichten eine oder mehrere Ladungsträgerbarriereschichten. Bei der Ladungsträgerbarriereschicht handelt es sich beispielsweise um eine Elektronenbarriereschicht, die in der p-anschlussseitigen Wellenleiterschicht eingebracht ist. Die Ladungsträgerbarriereschicht kann einen erhöhten Al-Gehalt und eine geringe Dicke zwischen einschließlich 0,25 nm und 20 nm aufweisen.

Gemäß zumindest einer Ausführungsform des optoelektronischen Halbleiterchips ist dieser zur Erzeugung einer Laserstrahlung eingerichtet. Mit anderen Worten ist der Halbleiterchip ein Laserchip.

Gemäß zumindest einer Ausführungsform des optoelektronischen Halbleiterchips ist dieser zur Erzeugung einer elektromagnetischen Strahlung zwischen einschließlich 430 nm und 540 nm eingerichtet. Mit anderen Worten emittiert der Halbleiterchip im blauen und/oder grünen Spektralbereich.

Darüber hinaus wird in einer nicht erfindungsgemäßen Abwandlung ein optoelektronischer Halbleiterchip angegeben, bei dem ein Aluminiumgehalt in mindestens einem aktiven Quantentrog variiert ist.

In einer nicht erfindungsgemäßen Abwandlung des optoelektronischen Halbleiterchips basiert dieser auf einem Nitrid-Materialsystem und weist mindestens einen aktiven Quantentrog auf, wobei in dem aktiven Quantentrog im Betrieb eine elektromagnetische Strahlung erzeugt wird. In einer Richtung parallel zu einer Wachstumsrichtung z des Halbleiterchips weist dieser N aufeinander folgende Zonen auf, wobei zumindest zwei der Zonen einen voneinander verschiedenen mittleren Aluminiumgehalt k aufweisen und N eine natürliche Zahl größer oder gleich 2 ist. Der mindestens eine aktive Quantentrog erfüllt hierbei die Bedingung:

$$70 \leq \int (35 - k(z))dz - 2{,}5N - 1{,}5\int dz \leq 120$$

für Strahlung mit Wellenlängen größer als 285 nm und insbesondere kleiner als oder gleich 360 nm, oder

$$50 \leq \int k(z)dz - 2{,}5N - 1{,}5\int dz \leq 100$$

für Strahlung mit Wellenlängen kleiner oder gleich 285 nm und insbesondere größer als oder gleich 210 nm.

Merkmale des Halbleiterchips, bei dem der mittlere Indiumgehalt der Zonen des aktiven Quantentrogs variiert ist, sind auch für die hier beschriebene nicht erfindungsgemäße Abwandlung des Halbleiterchips mit variiertem Aluminiumgehalt offenbart. Da mit zunehmendem Indiumgehalt eine Bandlücke abnimmt und mit zunehmendem Aluminiumgehalt eine Bandlücke zunimmt, sind Relationszeichen bezüglich des Indiumgehalts für den Fall eines variierten mittleren Aluminiumgehalts der Zonen des aktiven Quantentrogs entsprechend umzukehren.

Einige Anwendungsbereiche, in denen hier beschriebene optoelektronische Halbleiterchips Verwendung finden können, sind etwa die Hinterleuchtungen von Displays oder Anzeigeeinrichtungen. Weiterhin können hier beschriebene Halbleiterchips auch in Beleuchtungseinrichtungen zu Projektionszwecken, in Scheinwerfern oder Lichtstrahlern oder bei der Allgemeinbeleuchtung eingesetzt werden.

Nachfolgend wird ein hier beschriebener optoelektronischer Halbleiterchip unter Bezugnahme auf die Zeichnung anhand von Ausführungsbeispielen und nicht erfindungsgemäßen Abwandlungen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

| | |
|---|---|
| Figuren 1 | eine schematische Schnittdarstellung einer Abwandlung eines Halbleiterchips (A) und eine schematische Darstellung dessen Bandstruktur (B), |
| Figur 2 | eine schematische Darstellung einer weiteren Abwandlung eines optoelektronischen Halbleiterchips, |
| Figur 3 | eine schematische Darstellung einer Abwandlung eines Halbleiterbauteils, |
| Figuren 4, 6, 8 und bis 15 | schematische Darstellungen von weiteren Abwandlungen von optoelektronischen Halbleiterchips, |
| Figuren 5, 7 und 9 | schematische Darstellungen von Ausführungsbeispielen von hier beschriebenen optoe- |

| | lektronischen Halbleiterchips, |
|---|---|
| Figuren 16 und 17 | schematische Darstellungen von Parametervariationen von Halbleiterchips, und |
| Figur 18 | eine schematische Darstellung einer Abwandlung eines optoelektronischen Halbleiterchips mit Zonen mit unterschiedlichem Aluminiumgehalt. |

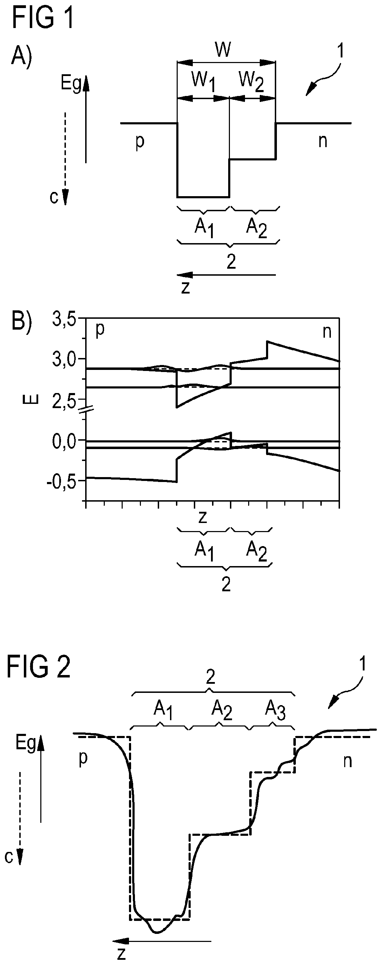

In Figur 1A ist eine Abwandlung eines optoelektronischen Halbleiterchips 1 schematisch anhand des Verlaufs eines Indiumgehalts c und einer Bandlücke $E_g$ entlang einer Wachstumsrichtung z dargestellt. Ein aktiver Quantentrog 2 weist im Vergleich zu den Quantentrog 2 umgebenden Gebieten des Halbleiterchips 1 einen höheren Indiumgehalt c auf. Der Quantentrog 2 umfasst zwei Zonen $A_{1, 2}$. In der ersten Zone $A_1$ des Quantentrogs 2 ist der Indiumgehalt c im Vergleich zu der zweiten Zone $A_2$ erhöht. Im Betrieb des Halbleiterchips 1 erfolgt eine Strahlungserzeugung bevorzugt näherungsweise ausschließlich in der ersten Zone $A_1$.

Der Halbleiterchip 1 beruht beispielsweise auf dem InGaN-Materialsystem. Die Bandlücke $E_g$ kann, für einen Indiumgehalt x in Prozent, näherungsweise wie folgt angegeben werden, siehe auch die Druckschrift Applied Physics Letters, Vol. 80, Issue 25, Jahrgang 2002, Seiten 4741 bis 4743:

$$E_g\ (x)\ =\ x\ \cdot\ 3{,}42\ +\ (1{-}x)\ \cdot\ 0{,}77\ -\ x\ \cdot\ (1{-}x)\ \cdot\ 1{,}43.$$

Die Bandlücke $E_g$ ist hierbei in eV angegeben. Mit zunehmendem Indiumgehalt nimmt die Bandlücke $E_g$ ab. Für eine Bandlücke $E_g$, entsprechend einer Wellenlänge von zirka 450 nm, beträgt der Indiumgehalt bevorzugt zwischen einschließlich 17 % und 22 %, entsprechend einer Wellenlänge von zirka 490 nm bevorzugt zwischen einschließlich 24 % und 29 %.

Näherungsweise ist der Indiumgehalt c in den Zonen $A_1$, $A_2$ jeweils konstant. Beispielsweise beträgt der Indiumgehalt $c_1$ der ersten Zone $A_1$ 22 % und der Indiumgehalt $c_2$ der zweiten Zone $A_2$ zirka 12 %. Eine Breite $w_1$ der ersten Zone $A_1$ liegt bei zirka 2,5 nm, eine Breite $w_2$ der zweiten Zone $A_2$ bei zirka 2 nm. Somit beträgt eine Gesamtbreite W des aktiven Quantentrogs 2 zirka 4,5 nm. Die Zonen $A_{1, 2}$ sind entgegen der Wachstumsrichtung z des Halbleiterchips 1 fortlaufend nummeriert. Die Nummerierung verläuft also in einer Richtung von einer p-Anschlussseite p hin zu einer n-Anschlussseite n des Halbleiterchips 1.

Wegen des in den Zonen $A_{1, 2}$ konstanten Indiumgehalts c kann der Term $\int c(z)dz{-}2{,}5N{-}1{,}5\int dz$ durch den Term

$$\sum_{i=1}^{N} c_i w_i - 2{,}5N - 1{,}5 \sum_{i=1}^{N} w_i$$ ausgedrückt werden. Der Indiumgehalt $c_i$ der i-ten Zone ist hierbei dimensionslos in Prozent anzugeben und die Breiten $w_i$ dimensionslos in Nanometer. N entspricht der Anzahl der Zonen $A_{1, 2}$. Für den aktiven Quantentrog 2 gemäß Figur 1A ergibt sich für den Term ein Wert von:

$$[22\ \cdot\ 2{,}5\ +\ 12\ \cdot\ 2]\ -\ [2{,}5\ \cdot\ 2]\ -\ [1{,}5\ \cdot\ (2{,}5\ +\ 2)]\ \approx\ 67.$$

Es ist möglich, den Wert des Terms für den aktiven Quantentrog 2 über ein Ausmessen des Quantentrogs 2 etwa mittels Elektronenmikroskopie, insbesondere Transmissionselektronenmikroskopie, zu ermitteln.

In Figur 1B ist schematisch ein Verlauf der Energien E des Valenzbands und des Leitungsbands des Halbleiterchips 1 gemäß Figur 1A entlang der Wachstumsrichtung z illustriert. Die Bandlücke $E_g$ entspricht der Differenz der Energien E des Valenzbandes und des Leitungsbandes, jeweils entlang der Wachstumsrichtung z. Wellenfunktionen des Valenzbandes und des Leitungsbandes sind jeweils als dicke Linien symbolisiert, die zugehörigen Energieniveaus als dünne horizontale Linien. Ein Überlappbereich der Wellenfunktionen der Grundzustände des Valenzbandes und des Leitungsbandes ist vergleichsweise groß. Hierdurch ist insbesondere eine hohe Rekombinationsrate von Ladungsträgern, also Elektronen und Löchern, in dem Quantentrog 2 ermöglicht. Auch die Einfangrate von Ladungsträgern in dem aktiven Quantentrog 2 kann erhöht sein.

In Figur 2 ist eine weitere Abwandlung eines Halbleiterchips 1 schematisch illustriert. Der Verlauf des Indiumgehalts c längs der Wachstumsrichtung z weist drei Zonen $A_{1, 2, 3}$ auf. Durch die drei Zonen ist der aktive Quantentrog 2 gebildet. Als Strichlinie ist ein angenäherter, mittlerer Indiumgehalt der Zonen $A_{1, 2, 3}$ dargestellt. Der reale Verlauf des Indiumgehalts c weist hiervon Abweichungen auf, insbesondere in den Bereichen der Kanten der als Strichlinie gezeichneten Stufen des idealisierten Verlaufs. Jedoch sind die einzelnen Zonen $A_{1, 2, 3}$ durch Bereiche eines starken Anstiegs beziehungsweise Abfalls des Indiumgehalts c deutlich voneinander separiert.

In den nachfolgend beschriebenen Ausführungsbeispielen und nicht erfindungsgemäßen Abwandlungen ist jeweils ein durch Stufen angenäherter, idealisierter Indiumgehalt c längs der Wachstumsrichtung z illustriert. Es ist also möglich, dass Abweichungen des Indiumgehalts c von den gezeigten Verläufen auftreten, analog zu Figur 2.

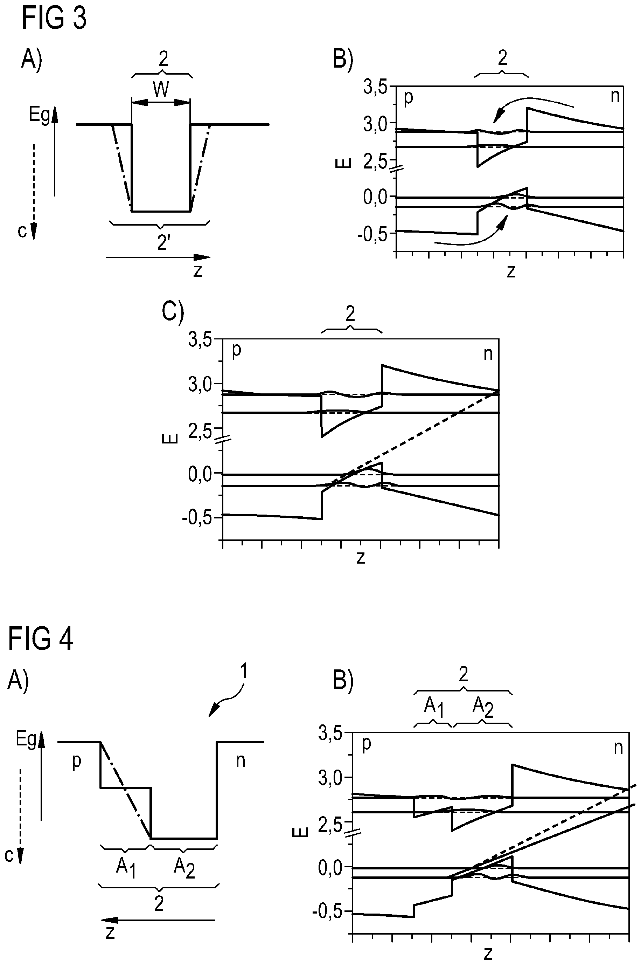

In Figur 3A ist eine Abwandlung eines Halbleiterbauteils dargestellt, bei dem der aktive Quantentrog 2 eine Breite W von zirka 6 nm und einen mittleren Indiumgehalt c von zirka 22 % aufweist. Der Term

$$\sum_{i=1}^{N} c_i w_i - 2{,}5N - 1{,}5\sum_{i=1}^{N} w_i$$

weist somit einen Wert von zirka 120 auf. Hierdurch weisen die Grundzustandswellenfunktionen im Valenzband und im Leitungsband, vergleiche Figuren 3B und 3C, nur einen verhältnismäßig geringen Überlapp miteinander auf. Zudem ist ein Gradient der Energien des Valenzbandes und des Leitungsbandes im Bereich des Quantentrogs 2 aufgrund von Piezofeldern vergleichsweise groß, symbolisiert durch eine geneigte Strichlinie in Figur 3C.

Es ist möglich, dass die Flanken des Quantentrogs 2 einen rampenartigen Verlauf aufzeigen und sich ein modifizierter aktiver Quantentrog 2' ergibt, symbolisiert durch eine Strich-Punkt-Linie.

Eine weitere Abwandlung des Halbleiterchips 1 ist in Figur 4 dargestellt. Die Zone $A_2$ mit dem höchsten Indiumgehalt $c_2$ des aktiven Quantentrogs 2 ist in Richtung hin zur p-Anschlussseite p von einer Zone $A_1$ benachbart, die einen kleineren mittleren Indiumgehalt $c_1$ aufweist. Die Zone $A_1$ kann auch rampenartig geformt sein, angedeutet durch eine Strich-Punkt-Linie.

Wie in Figur 4B zu sehen ist, ist verglichen mit Figur 3C aufgrund der Zone $A_1$ der Gradient der Energie E längs der Wachstumsrichtung z im Bereich der Zone $A_2$ mit dem maximalen Indiumgehalt $c_2$ signifikant reduziert, angedeutet in Figur 4B durch eine dick gezeichnete Linie. Zum direkten Vergleich ist in Figur 4B nochmals die Steigung der Energie E des Quantentrogs 2 gemäß Figur 3C als Strich-Linie eingezeichnet. Mit anderen Worten ist durch die Zone $A_1$ ein Gradient im Potentialverlauf reduziert. Diese Reduzierung des Gradienten führt zu einer erhöhten Effizienz bezüglich der Strahlungserzeugung in dem aktiven Quantentrog 2.

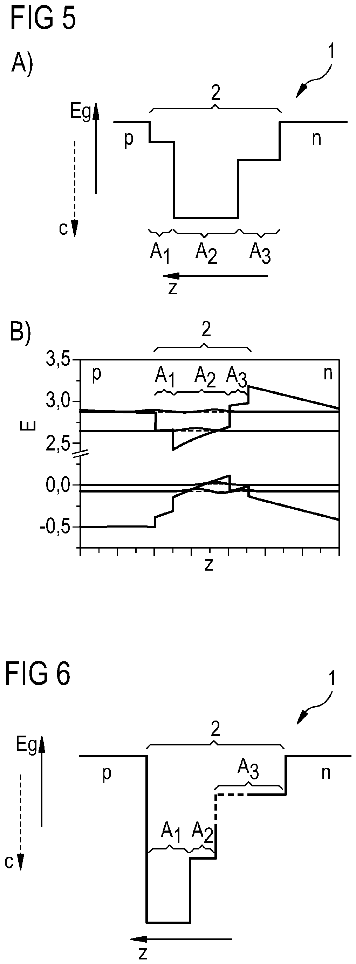

Beim Ausführungsbeispiel des Halbleiterchips 1 gemäß Figur 5 weist der aktive Quantentrog 2 drei Zonen $A_{1, 2, 3}$ auf. Die Zone $A_2$ mit dem maximalen Indiumgehalt $c_2$ weist die größte Breite $w_2$ auf. Der Indiumgehalt $c_1$ der p-anschlussseitigen Zone $A_1$ ist kleiner als der Indiumgehalt $c_3$ der n-anschlussseitigen Zone $A_3$. Entsprechendes gilt für die Breiten $w_{1, 3}$ der Zonen $A_{1, 3}$.

Wie in Figur 5B zu sehen ist, weist der Quantentrog 2 eine vergleichsweise große effektiv Breite und somit eine hohe Ladungsträgereinfangrate auf. Ebenfalls ist der Gradient im Potentialverlauf reduziert. Durch lokale Ladungen an den Heterogrenzen zwischen den Zonen $A_{1, 3}$ und dem umgebenden Halbleitermaterial außerhalb des aktiven Quantentrogs 2 sind Piezofelder reduziert. Hierdurch ist eine besonders hohe Effizienz bei der Strahlungserzeugung in dem Quantentrog 2 erzielbar.

Bei der Abwandlung gemäß Figur 6 weist der aktive Quantentrog 2 drei Zonen $A_{1, 2, 3}$ auf. Der Indiumgehalt $c_i$ steigt entgegen der Wachstumsrichtung z, ausgehend von der Zone $A_1$, monoton an. Die Stufenkante zwischen den Zonen $A_{2, 3}$ kann, angedeutet durch eine Punktlinie, beispielsweise auch, anders als in Figur 6 gezeichnet, abgerundet geformt sein. Anders als in Figur 6 dargestellt, kann der aktive Quantentrog 2 ebenso deutlich mehr als drei Zonen $A_{1, 2, 3}$ aufweisen.

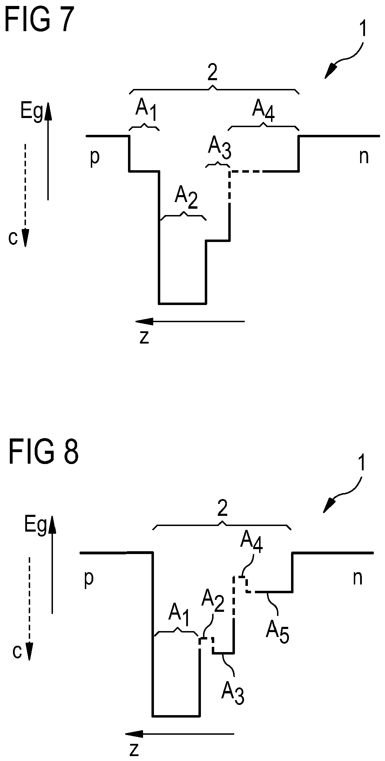

Beim Ausführungsbeispiel gemäß Figur 7 weist der aktive Quantentrog 2 sowohl eine p-anschlussseitige Zone $A_1$ als auch mehrere n-anschlussseitige Zonen $A_{3, 4}$ auf, die die Zone $A_2$ mit dem maximalen mittleren Indiumgehalt $c_2$ umgeben.

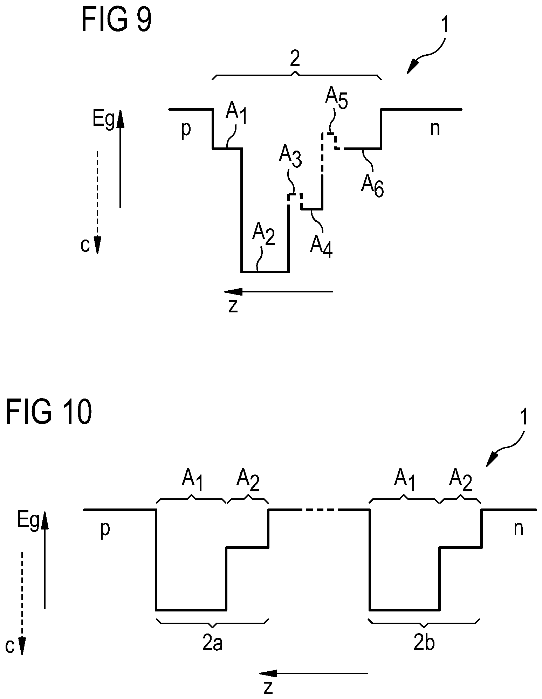

Bei der Abwandlung des Halbleiterchips 1 gemäß Figur 8 weist der aktive Quantentrog 2 zwei Zwischenbarrieren auf, die durch die Zonen $A_{2, 4}$ gebildet sind. Der Indiumgehalt $c_{2, 4}$ der Zonen $A_{2, 4}$ ist im Vergleich zu den jeweils benachbarten Zonen erniedrigt und/oder ein Aluminiumgehalt der Zonen ist $A_{2, 4}$ erhöht. Beim Ausführungsbeispiel gemäß Figur 9 ist weiterhin zusätzlich eine p-anschlussseitige Zone $A_1$ mit niedrigerem Indiumgehalt $c_1$ vorhanden.

Gemäß Figur 10 weist die Abwandlung des Halbleiterchips 1 zwei aktive Quantentröge 2a, b auf. Jeder der Quantentröge 2a, b umfasst zwei Zonen $A_{1, 2}$. Anders als in Figur 10 dargestellt, angedeutet durch die Punktlinie zwischen den aktiven Quantentrögen 2a, b, kann der Halbleiterchip 1 beispielsweise auch drei, vier, fünf oder mehr aktive Quantentröge aufweisen.

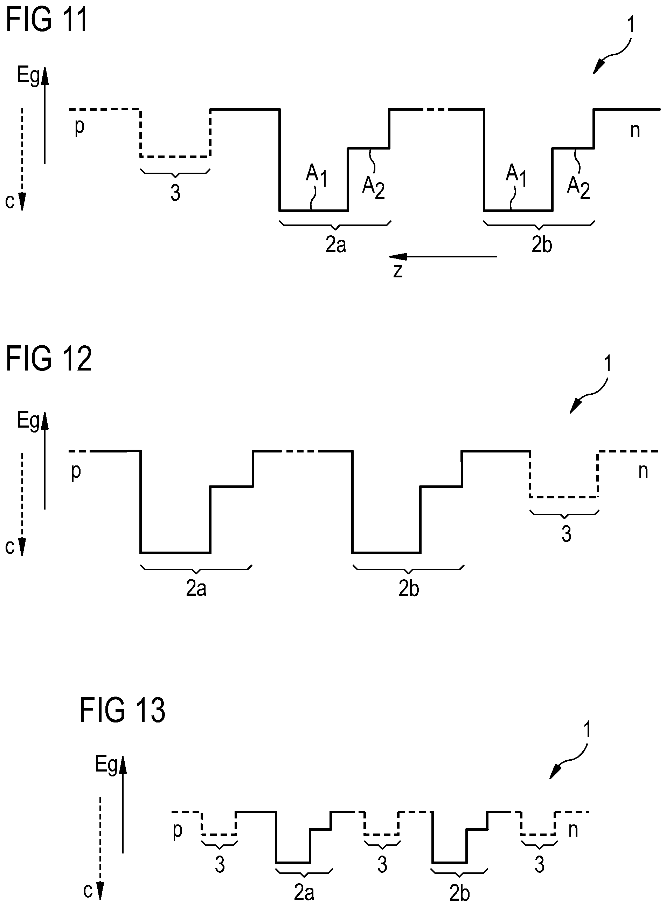

Gemäß der Abwandlung nach Figur 11 umfasst der Halbleiterchip 1 neben den aktiven Quantentrögen 2a, 2b auch einen inaktiven Quantentrog 3. Ein Indiumgehalt des inaktiven Quantentrogs 3 liegt beispielsweise zwischen dem der Zonen $A_{1, 2}$ der aktiven Quantentröge 2a, b. Der inaktive Quantentrog 3 befindet sich an der p-Anschlussseite p des Halbleiterchips 1. Anders als in Figur 11 dargestellt ist es ebenso möglich, dass auch der inaktive Quantentrog 3 mehrere Zonen mit unterschiedlichem Indiumgehalt und/oder Aluminiumgehalt umfasst.

In Figur 12 ist eine Abwandlung dargestellt, wonach sich der inaktive Quantentrog 3 auch an der n-Anschlussseite n befinden kann. Es ist auch möglich, dass Gruppen mit bis zu fünf inaktiven Quantentrögen 3 an der n-Anschlussseite n und/oder an der p-Anschlussseite p gebildet sind. Es ist hierbei nicht notwendig, dass die verschiedenen Gruppen von inaktiven Quantentrögen 3 jeweils eine gleiche Anzahl an inaktiven Quantentrögen 3 aufweisen. Entsprechendes gilt, siehe Figur 13, auf für einen inaktiven Quantentrog 3 oder eine Gruppe mit mehreren inaktiven Quantentrögen 3, die sich zwischen den aktiven Quantentrögen 2a, b befindet.

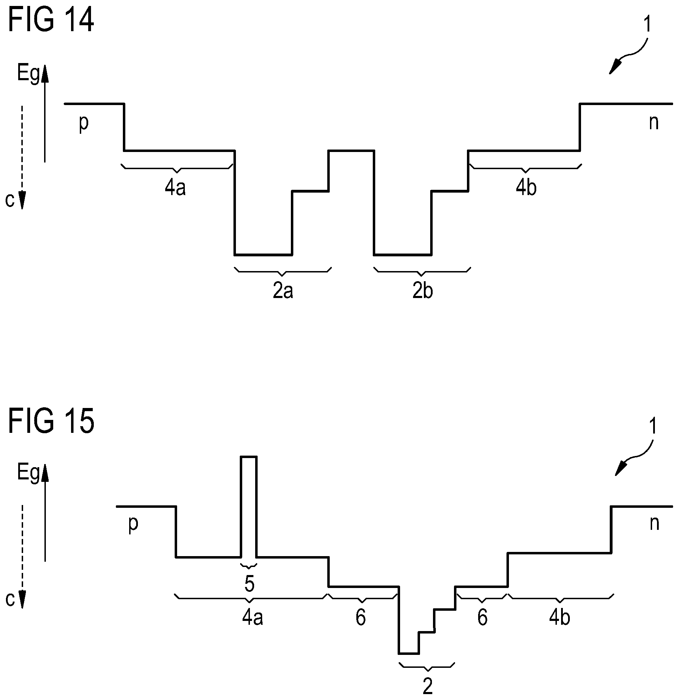

Gemäß der Abwandlung nach Figur 14 beinhaltet der optoelektronische Halbleiterchip 1 ferner zwei Mantelschichten 4a, b, die die aktiven Quantentröge 2a, b einschließen oder einfassen.

Bei der Abwandlung gemäß Figur 15 weist der Halbleiterchip 1 zwischen dem aktiven Quantentrog 2 und den Wellenleiterschichten 4a, b weiterhin jeweils eine Barriereschicht 6 auf. Zudem umfasst die p-anschlussseitige Wellenleiterschicht 4a eine Ladungsträgerbarriereschicht 5. Die Ladungsträgerbarriereschicht 5 ist beispielsweise durch eine dünne Schicht mit einem erhöhten Aluminiumgehalt gebildet.

Anders als in Figur 15 dargestellt, kann der Halbleiterchip 1 auch mehrere aktive Quantentröge 2 und optional ebenso einen oder mehrere inaktive Quantentröge 3 aufweisen.

Bei den Abwandlungen beziehungsweise Beispielen des Halbleiterchips 1 gemäß der Figuren 1, 2 und 4 bis 15 ist der mindestens eine aktive Quantentrog 2 bezüglich Anzahl N der Zonen A, Indiumgehalt c und Breiten w der Zonen A jeweils so gestaltet, dass der Term

$$\int c(z)dz - 2,5N - 1,5\int dz$$

oder

$$\sum_{i=1}^{N} c_i w_i - 2,5N - 1,5\sum_{i=1}^{N} w_i$$

eine Größe zwischen einschließlich 40 und 80, insbesondere zwischen einschließlich 50 und 70 aufweist.

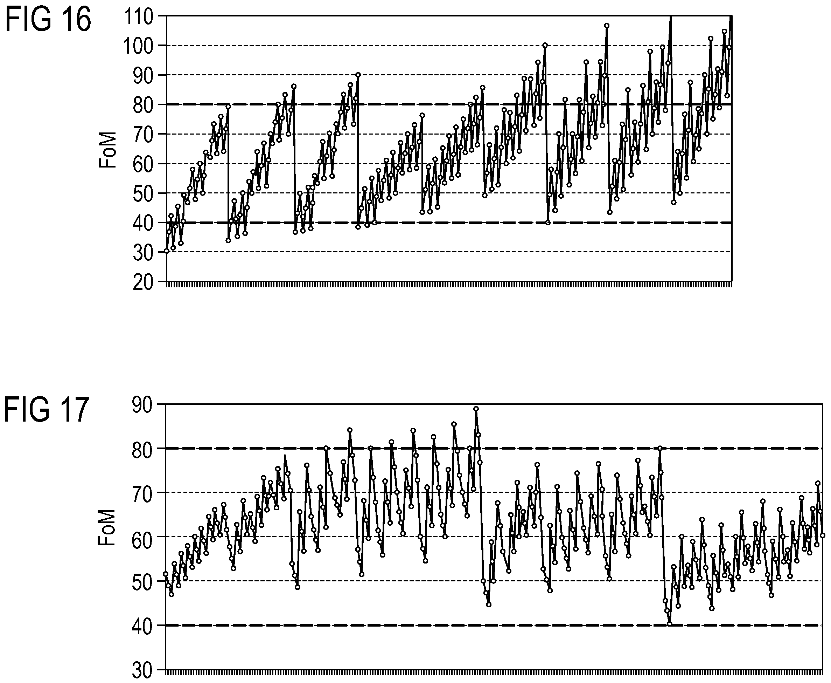

In den Figuren 16 und 17 ist eine Parametervariation bezüglich des Indiumgehalts c und der Breiten w der Zonen A des aktiven Quantentrogs 2 von Halbleiterchips schematisch illustriert. Für die jeweiligen Variationen der Parameter wurde der Wert des Terms

$$\int c(z)dz - 2,5N - 1,5\int dz \;,$$

kurz FoM, entlang der Abszissenachse aufgetragen. Gemäß Figur 16 weist der aktive Quantentrog jeweils zwei Zonen A auf. Zwischen FoM-Werten von 40 und 80, insbesondere zwischen 50 und 70, zeigen die Halbleiterchips eine hohe Effizienz auf, die sich beispielsweise in einer Lasertätigkeit äußert. Entsprechendes gilt für die Halbleiterchips gemäß Figur 17, bei dem der aktive Quantentrog jeweils drei Zonen A aufweist.

Beispielsweise ist ein Wirkungsgrad der Halbleiterchips in den angegebenen FoM-Wertebereichen größer als außerhalb dieser Wertebereiche, wobei der Wirkungsgrad der Quotient aus einer emittierten optischen Ausgangsleistung und einer elektrischen Eingangsleistung, mit der die Halbleiterchips betrieben werden, ist. Bei einer Wellenlänge der emittierten Strahlung von zirka 440 nm und einer optischen Ausgangsleistung von 30 mW kann der Wirkungsgrad für FoM-Werte außerhalb der angegebenen Bereiche kleiner als 6 % sein, und für FoM-Werte insbesondere zwischen einschließlich 50 und 70 größer als oder gleich 8 % sein. Für eine Wellenlänge von zirka 480 nm und einer Ausgangsleistung von 5 mW ist es möglich, dass der Wirkungsgrad für FoM-Werte außerhalb der angegebenen Bereiche unterhalb von 0,5 % liegt, und für FoM-Werte insbesondere zwischen einschließlich 50 und 70 mindestens 0,6 %, bevorzugt mindestens 0,8 % beträgt.

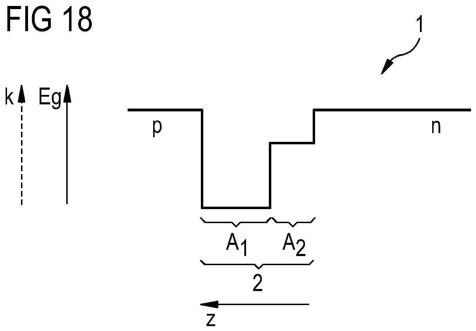

In Figur 18 ist eine Abwandlung eines Halbleiterchips 1 illustriert, bei dem ein Aluminiumgehalt k entlang der Wachstumsrichtung z des aktiven Quantentrogs 2 in zwei Zonen $A_{1,2}$ unterschiedlich eingestellt ist. Der Aluminiumgehalt k und Dicken der Zonen $A_{1,2}$ sind derart gewählt, dass der aktive Quantentrog 2 die Bedingung erfüllt:

$$50 \leq \int (35 - k(z))dz - 2,5N - 1,5\int dz \leq 120 \;.$$

Auch die Abwandlung gemäß Figur 18 kann inaktive Quantentröge, mehrere aktive Quantentröge und/oder Mantelschichten und Barriereschichten aufweisen, beispielsweise analog zur Abwandlung gemäß Figur 15.

Auch ist es möglich, dass eine Einstellung des Aluminiumgehalts k der Zonen A des aktiven Quantentrogs 2 mit einer Einstellung des Indiumgehalts c, etwa gemäß den Figuren 1, 2 und 4 bis 15, kombiniert ist.

**Patentansprüche**

1.  Optoelektronischer Halbleiterchip (1), basierend auf einem Nitrid-Materialsystem, mit mindestens einem aktiven Quantentrog (2), wobei

    - in dem aktiven Quantentrog (2) im Betrieb eine elektromagnetische Strahlung erzeugt wird,
    - der aktive Quantentrog (2) in einer Richtung parallel zu einer Wachstumsrichtung z des Halbleiterchips (1) N aufeinander folgende Zonen (A) aufweist und N eine natürliche Zahl größer oder gleich 3 ist,
    - zumindest zwei der Zonen (A) einen voneinander verschiedenen mittleren Indiumgehalt c aufweisen, und
    - der aktive Quantentrog (2) die Bedingung erfüllt:

$$40 \leq \sum_{i=1}^{N} c_i w_i - 2{,}5N - 1{,}5\sum_{i=1}^{N} w_i \leq 80 \, ,$$

    wobei $c_i$ der mittlere Indiumgehalt der i-ten Zone (A) und $w_i$ eine Breite der i-ten Zone (A) ist und die Zonen (A) in einer Richtung parallel zur Wachstumsrichtung z fortlaufend nummeriert sind,
    wobei der Indiumgehalt c innerhalb der Zonen (A) des mindestens einen aktiven Quantentrogs (2) jeweils konstant ist,
    wobei der Indiumgehalt c dimensionslos in Prozent und w dimensionslos in Nanometer angegeben ist,
    wobei, in einer Richtung parallel zur Wachstumsrichtung z und von einer p-Anschlussseite (p) hin zu einer n-Anschlussseite (n) des Halbleiterchips (1), für den mittleren Indiumgehalt für zumindest einen Teil der Zonen (A) gilt:
    $c_i < c_{i+1}$ und $c_{i+1} > c_{i+2}$,
    **dadurch gekennzeichnet, dass**
    $c_i < c_{i+2}$.

2.  Optoelektronischer Halbleiterchip (1) nach dem vorhergehenden Anspruch,
    bei dem, in einer Richtung parallel zur Wachstumsrichtung z und von einer p-Anschlussseite (p) hin zu einer n-Anschlussseite (n) des Halbleiterchips (1), für den mittleren Indiumgehalt für einen Teil der Zonen (A) gilt:
    $c_j > c_{j+1}$ und $c_{j+2} > c_{j+1}$ und $c_j > c_{j+2}$,
    wobei die Zonen (A) in einer Richtung parallel zur Wachstumsrichtung z fortlaufend mit j nummeriert sind.

3.  Optoelektronischer Halbleiterchip (1) nach einem der vorhergehenden Ansprüche,
    bei dem N zwischen einschließlich 3 und 10 liegt und bei dem eine Gesamtbreite (W) des aktiven Quantentrogs (2) zwischen einschließlich 0,25 nm und 12 nm liegt.

4.  Optoelektronischer Halbleiterchip (1) nach einem der vorhergehenden Ansprüche,
    der, in einer Richtung parallel zur Wachstumsrichtung z, zwischen einschließlich 2 und 5 aktive Quantentröge (2) aufweist.

5.  Optoelektronischer Halbleiterchip (1) nach einem der vorhergehenden Ansprüche,
    der mindestens 2 inaktive Quantentröge (3) umfasst, wobei ein Indiumgehalt der inaktiven Quantentröge (3) jeweils kleiner ist als ein maximaler Indiumgehalt des mindestens einen aktiven Quantentrogs (2).

6.  Optoelektronischer Halbleiterchip (1) nach den Ansprüchen 4 und 5,
    bei dem sich zwischen zumindest zwei benachbarten aktiven Quantentrögen (2) wenigstens ein inaktiver Quantentrog (3) befindet.

7.  Optoelektronischer Halbleiterchip (1) nach einem der vorhergehenden Ansprüche,
    der wenigstens zwei Wellenleiterschichten (4) umfasst, wobei der mindestens eine aktive Quantentrog (2) sich zwischen den Wellenleiterschichten (4) befindet, und wobei mindestens eine der Wellenleiterschichten (4) zumindest eine Ladungsträgerbarriereschicht (5) beinhaltet.

8. Optoelektronischer Halbleiterchip (1) nach einem der vorhergehenden Ansprüche,
der zur Erzeugung einer Laserstrahlung eingerichtet ist.

9. Optoelektronischer Halbleiterchip (1) nach einem der vorhergehenden Ansprüche,
der zur Erzeugung einer elektromagnetischen Strahlung zwischen einschließlich 430 nm und 540 nm eingerichtet ist.

**Claims**

1. An optoelectronic semiconductor chip (1), based on a nitride material system, comprising at least one active quantum well (2), wherein

   - an electromagnetic radiation is generated in the active quantum well (2) during operation,
   - in a direction parallel to a growth direction z of the semiconductor chip (1), the active quantum well (2) comprises N consecutive zones (A) and N is a natural number greater than or equal to 3,
   - at least two of the zones (A) have a different mean indium content c, and
   - the active quantum well (2) satisfies the condition:

   $$40 \leq \sum_{i=1}^{N} c_i w_i - 2{,}5N - 1{,}5\sum_{i=1}^{N} w_i \leq 80 \quad,$$

   wherein $c_i$ is the average indium content of the i-th zone (A) and $w_i$ is a width of the i-th zone and the zones (A) are continuously numbered in a direction parallel to the growth direction z,
   wherein the indium content c within the zones (A) of the at least one active quantum well (2) is in each case constant, wherein the indium content c being specified dimensionless in percent and w being specified dimensionless in nanometers, wherein, in a direction parallel to the growth direction z and from a p-connection side (p) to an n-connection side (n) of the semiconductor chip (1), for the average indium content for at least some of the zones (A) it applies:
   $c_i < c_{i+1}$ and $c_{i+1} > c_{i+2}$,
   **characterized in that**
   $c_i < c_{i+2}$.

2. The optoelectronic semiconductor chip (1) according to the preceding claim,
in which, in a direction parallel to the growth direction z and from the p-connection side (P) to the n-connection side (n) of the semiconductor chip (1), for the average indium content for a part of the zones (A) it applies:

   $c_j > c_{j+1}$ and $c_{j+2} > c_{j+1}$ and $c_j > c_{j+2}$,
   wherein the zones (A) are continuously numbered with j in a direction parallel to the growth direction z.

3. The optoelectronic semiconductor chip (1) according to one of the preceding claims,
wherein N is between 3 and 10 inclusive and in which a total width (W) of the active quantum well (2) is between 0.25 nm and 12 nm inclusive.

4. The optoelectronic semiconductor chip (1) according to one of the preceding claims,
comprising between 2 and 5 inclusive active quantum wells (2), in a direction parallel to the growth direction z.

5. The optoelectronic semiconductor chip (1) according to one of the preceding claims,
comprising at least two inactive quantum wells (3),
wherein an indium content of the inactive quantum wells (3) is smaller than a maximum indium content of the at least one active quantum well (2).

6. The optoelectronic semiconductor chip (1) according to claims 4 and 5,
in which at least one inactive quantum well (3) is located between at least two adjacent active quantum wells (2).

7. The an optoelectronic semiconductor chip (1) according to one of the preceding claims,
comprising at least two waveguide layers (4),

wherein the at least one active quantum well (2) is located between the waveguide layers (4), and
wherein at least one of the waveguide layers (4) contains at least one charge carrier barrier layer (5).

8. The optoelectronic semiconductor chip (1) according to one of the preceding claims,
which is configured to generate a laser radiation.

9. The optoelectronic semiconductor chip (1) according to one of the preceding claims,
which is configured to generate an electromagnetic radiation between 430 nm and 540 nm inclusive.

**Revendications**

1. Puce optoélectronique semi-conductrice (1) basée sur un système de matériau nitrure comprenant au moins un puits quantique actif (2), dans laquelle

   - un rayonnement électromagnétique est généré dans le puits quantique actif (2) durant le fonctionnement,
   - le puits quantique actif (2) présente N zones successives (A) dans une direction parallèle à une direction de croissance z de la puce semi-conductrice (1) et N est un nombre naturel supérieur ou égal à 3,
   - au moins deux des zones (A) ont une teneur moyenne en indium c différente, et
   - le puits quantique actif (2) satisfait à la condition :

$$40 \leq \sum_{i=1}^{N} c_i w_i - 2{,}5N - 1{,}5\sum_{i=1}^{N} w_i \leq 80$$

   dans laquelle $c_i$ est la teneur moyenne en indium de la i-ème zone (A) et $w_i$ est une largeur de la i-ème zone (A), et les zones (A) sont numérotées consécutivement dans une direction parallèle à la direction de croissance z, la teneur en indium c étant constante dans les zones (A) d'au moins un puits quantique actif (2), la teneur en indium c étant indiquée sans dimension en pourcentage et w sans dimension en nanomètres, dans laquelle, dans une direction parallèle à la direction de croissance z et d'un conducteur de raccordement p (p) à un conducteur de raccordement n (n) de la puce semi-conductrice (1), la formule suivante est valable pour la teneur moyenne en indium d'au moins une partie des zones (A) :
   $c_i < c_{i+1}$ et $c_{i+1} > c_{i+2}$,
   **caractérisé en ce que**
   $c_i < c_{i+2}$.

2. Puce optoélectronique semi-conductrice (1) selon la revendication précédente,
dans laquelle, dans une direction parallèle à la direction de croissance z et d'un conducteur de raccordement p (p) à un conducteur de raccordement n (n) de la puce semi-conductrice (1), la formule suivante est valable pour la teneur moyenne en indium d'une partie des zones (A) :
$c_j > c_{j+1}$ et $c_{j+2} > c_{j+1}$ et $c_j > c_{j+2}$,
les zones (A) étant numérotées consécutivement j dans une direction parallèle à la direction de croissance z.

3. Puce optoélectronique semi-conductrice (1) selon l'une des revendications précédentes,
dans laquelle N est compris entre 3 et 10 inclus et dans laquelle une largeur totale (W) du puits quantique actif (2) est comprise entre 0,25 nm et 12 nm inclus.

4. Puce optoélectronique semi-conductrice (1) selon l'une des revendications précédentes,
présentant, dans une direction parallèle à la direction de croissance z, entre 2 et 5 puits quantiques actifs (2) .

5. Puce optoélectronique semi-conductrice (1) selon l'une des revendications précédentes,
comprenant au moins 2 puits quantiques inactifs (3),
dans laquelle une teneur en indium des puits quantiques inactifs (3) est respectivement inférieure à une teneur maximale en indium d'au moins un puits quantique actif (2) .

6. Puce optoélectronique semi-conductrice (1) selon les revendications 4 et 5,
dans laquelle au moins un puits quantique inactif (3) est situé entre au moins deux puits quantiques actifs adjacents (2) .

7.  Puce optoélectronique semi-conductrice (1) selon l'une des revendications précédentes, comprenant au moins deux couches de guide d'ondes (4), dans laquelle au moins un puits quantique actif (2) est situé entre les couches de guide d'ondes (4), au moins l'une des couches de guide d'ondes (4) comprenant au moins une couche barrière porteuse de charge (5).

8.  Puce optoélectronique semi-conductrice (1) selon l'une des revendications précédentes, conçue pour générer un rayonnement laser.

9.  Puce optoélectronique semi-conductrice (1) selon l'une des revendications précédentes, configurée pour générer un rayonnement électromagnétique compris entre 430 nm et 540 nm inclus.

FIG 1

A)

B)

FIG 2

FIG 3

FIG 4

## FIG 5

A)

B)

## FIG 6

FIG 7

FIG 8

FIG 9

FIG 10

FIG 11

FIG 12

FIG 13

FIG 14

FIG 15

FIG 16

EP 2 415 085 B1

FIG 17

FIG 18

k    Eg

p                                    n

A₁    A₂

2

z

**IN DER BESCHREIBUNG AUFGEFÜHRTE DOKUMENTE**

**In der Beschreibung aufgeführte Patentdokumente**

- US 6849881 B1
- JP 2004356256 A
- EP 1667292 A1
- WO 2007023419 A1
- US 20050116216 A

**In der Beschreibung aufgeführte Nicht-Patentliteratur**

- *Druckschrift Applied Physics Letters,* 2002, vol. 80 (25), 4741-4743